# EUROPEAN PATENT APPLICATION

(11) **EP 4 431 966 A1**
(43) Date of publication of application: **18.09.2024**
(21) Application number: 22905792.2
(22) Date of filing: 01.06.2022
(51) Int. Cl.: G01R 33/385

(54) **SHIMMING DEVICE, MAGNETIC FIELD ASSEMBLY, MAGNETIC RESONANCE IMAGING SYSTEM, AND SHIMMING METHOD**

(30) Priority: 16.12.2021 CN 202111543730
(71) Applicant: Wuhan United Imaging Life Science Instrument Co., Ltd, Wuhan, Hubei 430206 (CN)
(72) Inventor: SHU, Shanyi, Wuhan, Hubei 430206 (CN); YANG, Jiwen, Shanghai 201807 (CN); LIU, Shuguang, Shanghai 201807 (CN)
(74) Representative: Wang, Bo
(86) International application number: PCT/CN2022/096516
(87) International publication number: WO 2023/109026

(57) **Abstract**

A shinnning device for a magnetic resonance imaging system, and a magnetic field assembly, a magnetic resonance imaging system and a shimming method. The magnetic resonance imaging system comprises a magnet (200) for generating a main magnetic field, and the magnet (200) is provided with a mounting cavity; and the shimming device comprises a shinnning stmcture for improving the magnetic field homogeneity of the main magnetic field, and the shinnning stmcture is provided in the mounting cavity. When a gradient coil (300) is replaced in the magnetic resonance imaging system, there is no need to synchronously replace the shinnning structure, and the magnetic resonance imaging system does not need to be subjected to a re-shinnning operation, such that the complexity of a scanning operation of the magnetic resonance imaging system is greatly reduced.

## Description

### CROSS-REFERENCE TO RELATED APPLICATION

This application claims priority to Chinese application No. 202111543730.2, filed on December 16, 2021, the entire contents of each of which is incorporated herein by reference.

### TECHNICAL FIELD

The present disclosure is related to a field of magnetic resonance imaging technology, and in particular to shimming devices, magnetic field assemblies, magnetic resonance imaging (MRI) systems, and shimming methods.

### BACKGROUND

Core components of a magnetic resonance imaging (MRI) system may include a magnet for providing a stable magnetic field environment. To improve an imaging quality of the MRI system, it may be necessary to deploy a magnetic field uniformity of the MRI system. To ensure the magnetic field uniformity of the MRI system, a shimming operation may be performed on the MRI system to make a magnetic field strength of the MRI system uniform.

Existing MRI systems may include a magnet and a gradient coil. The gradient coil may be provided within the magnet, and existing passive field shimming plans may generally have a plurality of shimming strips provided within the gradient coil. Each of the plurality of shimming strips has a cell capable of housing a shimming sheet. The shimming sheet may be adjusted by adjusting the magnetic field uniformity of the MRI system.

For an ultra-high-field MRI system, gradient coils with different aperture diameters may be provided for different scenarios and scanning objects. The shimming sheet disposed inside the gradient coil may cause the shimming sheet is taken away by the gradient coil when the gradient coil is being replaced, thus leading to a need to perform the shimming operation again when using a new gradient coil, which is complicated and inefficient. Additionally, during a scanning process of the MRI system, the gradient coil may heat the shimming sheet, resulting in a severe field drift of the shimming sheet, which affects a scanning accuracy of the MRI system.

### SUMMARY

The first aspect of embodiments of the present disclosure discloses a shimming device for a magnetic resonance imaging (MRI) system. The MRI system may include a magnet for generating a main magnetic field. The magnet may be provided with a mounting cavity. The shimming device may include a shimming structure disposed within the mounting cavity.

In some embodiments, the mounting cavity may be configured to mount a gradient coil. An outer wall of the gradient coil may form an annular mounting gap with an inner wall of the magnet, and the shimming structure may be disposed within the annular mounting gap.

In some embodiments, the shimming structure may include a plurality of shimming units extending along an axial direction of the mounting cavity. The plurality of shimming units may be distributed along a circumferential direction of an inner wall of the mounting cavity.

In some embodiments, the plurality of shimming units may be provided with a plurality of placement slots distributed along the axial direction of the mounting cavity. Openings of the plurality of placement slots may be oriented towards a side away from the magnet. The placement slots may be configured to mount shimming sheets.

In some embodiments, the plurality of the placement slots may be distributed in a middle portion of a lengthwise direction of the plurality of shimming units.

In some embodiments, each shimming unit of the plurality of shimming units may include a main shimming strip extending along the axial direction of the mounting cavity. At least a portion of the plurality of the shimming units may include an auxiliary shimming strip extending along the axial direction of the mounting cavity. The auxiliary shimming strip may be assembled on a side of the main shimming strip along a circumference of the mounting cavity.

In some embodiments, the plurality of shimming units may include two auxiliary shimming strips assembled on both sides of the main shimming strip along the circumferential direction of the mounting cavity; and/or the plurality of shimming units may include an auxiliary shimming strip assembled on one side of the main shimming strip along the circumferential direction of the mounting cavity.

In some embodiments, the shimming structure may further include a fixing ring. One end of the main shimming strip may be detachably mounted on the fixing ring. The other end of the main shimming strip may be connected to the auxiliary shimming strip.

In some embodiments, the magnet may be connected with a plurality of limit strips distributed along a circumferential direction of the inner wall of the magnet. At least a portion of adjacent limit strips and the inner wall of the magnet may enclose and form a first limit slot extending along an axial direction of the mounting cavity. At least a portion of the plurality of shimming units may be disposed within the first limit slot.

In some embodiments, each of the plurality of limit strips may have a T-shaped cross-section and the plurality of limit strips may be connected to the inner wall of the magnet.

A second aspect of embodiments of the present disclosure discloses a magnetic field assembly for the MRI system. The magnetic field assembly may include a magnet and a limit structure for mounting a plurality of shimming units. The magnet may be provided with a mounting cavity. The limit structure may include a plurality of limit strips distributed along a circumferential direction of the mounting cavity. The plurality of limit strips may be connected to an inner wall of the magnet. At least a portion of adjacent limit strips and the inner wall of the magnet may enclose and form a first limit slot extending along an axial direction of the mounting cavity. The first limit slot may be configured to mount at least a portion of the plurality of shimming units.

In some embodiments, the limit structure may further include at least two support strips distributed along a circumferential direction of the inner wall of the magnet on both sides of a symmetry axis of the inner wall of the magnet. The symmetry axis may be along a direction of gravity. The at least two support strips may be connected to the inner wall.

In some embodiments, the support strip may be provided adjacent to at least one of the plurality of limit strips. The support strip, an adjacent limit strip, and the inner wall of the magnet may enclose and form a second limit slot extending along the axial direction of the mounting cavity. At least a portion of the plurality of shimming units may be disposed within the second limit slot.

A third aspect of embodiments of the present disclosure discloses an MRI system including a magnet and a shimming devicedescribed in any of the above embodiments. The magnet may be provided with a mounting cavity, and a shimming device may be disposed within the mounting cavity.

In some embodiments, the MRI system may further include a gradient coil. The shimming device may be disposed between the magnet and the gradient coil. There may be a gap between the shimming device and the gradient coil.

In some embodiments, the magnet may further be connected to at least two support strips. The at least two support strips may be distributed along a circumferential direction of an inner wall of the magnet. The at least two support strips may abut against the gradient coil.

In some embodiments, the at least two support strips may be distributed on both sides of a symmetry axis of the inner wall of the magnet along a direction of gravity.

In some embodiments, the support strip of the at least two support strips may be provided adjacent to at least one of a plurality of limit strips. The support strip, an adjacent limit strip, and the inner wall of the magnet may enclose and form a second limit slot extending along an axial direction of the mounting cavity. At least a portion of a plurality of shimming units may be disposed within the second limit slot.

A fourth aspect of embodiments of the present disclosure discloses a shimming method for a MRI system. A shimming device with a main shimming strip and an auxiliary shimming strip may be used. The shimming method may include the steps of: measuring a first magnetic field distribution of a main magnetic field of a magnet for a first time; mounting, based on the first magnetic field distribution, the main shimming strip with a main shimming sheet between a magnet and a gradient coil; measuring a second magnetic field distribution of the main magnetic field of the magnet for a second time; and mounting, based on the second magnetic field distribution, the auxiliary shimming strip with an auxiliary shimming sheet between the main shimming strip.

In some embodiments, the first magnetic field distribution of the main magnetic field of the magnet may be measured at a factory, and the second magnetic field distribution of the main magnetic field of the magnet may be measured at an installation site of the shimming device.

### BRIEF DESCRIPTION OF THE DRAWINGS

FIG. 1 is a schematic diagram illustrating a structure of a magnetic resonance imaging (MRI) system according to some embodiments of the present disclosure;
FIG. 2 is a schematic diagram illustrating a structure of a magnet according to some embodiments of the present disclosure;
FIG. 3 is a schematic diagram illustrating a mounting structure of a shimming device and a gradient coil according to some embodiments of the present disclosure;
FIG. 4 is a schematic diagram illustrating a structure of a shimming device according to some embodiments of the present disclosure;
FIG.5 is an enlarged view at B shown in FIG.4;
FIG. 6 is an exploded diagram illustrating a shimming device according to some embodiments of the present disclosure;
FIG. 7 is a schematic diagram illustrating a structure of a shimming unit according to some embodiments of the present disclosure;
FIG. 8 is an exploded diagram illustrating a shimming unit according to some embodiments of the present disclosure;
FIG.9 is an enlarged view at A shown in FIG.8;
FIG. 10 is a schematic diagram illustrating a structure of a shimming sheet according to some embodiments of the present disclosure;
FIG. 11 is a schematic diagram illustrating a structure of a slot cover according to some embodiments of the present disclosure;
FIG. 12 is a schematic diagram illustrating a structure of a limit strip according to some embodiments of the present disclosure;
FIG. 13 is a schematic diagram illustrating a structure of a magnetic field assembly according to some embodiments of the present disclosure; and
FIG. 14 is a schematic diagram illustrating a structure of a support strip according to some embodiments of the present disclosure.

Reference Signs: 100: shimming device; 110: shimming structure; 111: shimming unit; 112: placement slot; 113: slot cover; 114: main shimming strip; 114a: second threaded hole; 114b: fourth threaded hole; 114c: first stop portion; 114d: second stop portion; 115: auxiliary shimming strip; 116: connection sheet; 116a: first threaded hole; 117: fixing ring; 117a: third threaded hole; 130: limit structure; 120: limit strip; 120a: snapping portion; 120b: connection portion; 121: first limit slot; 122: second limit slot; 123: support strip; 200: magnet; 201: mounting cavity; 300: gradient coil; 400: mounting gap; 500: shimming sheet; 500a: main shimming sheet; 500b: auxiliary shimming sheet.

### DETAILED DESCRIPTION

In technical solutions in the embodiments of the present disclosure will be clearly and completely described below in conjunction with the accompanying drawings in the embodiments of the present disclosure, and it is clear that the embodiments described are only a portion of the embodiments of the present disclosure, and not all of them. Based on the embodiments in the present disclosure, all other embodiments obtained by those skilled in the art without making creative labor fall within the scope of protection of the disclosure.

In the description of the present disclosure, it is to be understood that the terms "center, " "longitudinal, " "horizontal," "length, "width," "thickness," "upper ," "bottom," "front," "back," "left," "right," "vertical," "aclinic," "top," "bottom ," "inside"," "outside," "clockwise," "counterclockwise," "axial, "radial," "circumferential," etc. indicate orientation or positional relationships based on those shown in the accompanying drawings, and are intended only to facilitate description of the disclosure and to simplify the description. They are not intended to indicate or imply that the device or element referred to must have a particular orientation, or be constructed and operated in a particular orientation, and therefore are not to be understood as a limitation of the disclosure.

Additionally, the terms "first" and "second" are used only for descriptive purposes and are not to be understood as indicating or implying relative importance or implicitly specifying the number of technical features indicated. Thus, the feature defined as "first," "second" may expressly or implicitly include at least one such feature. In the description of the present disclosure, "plurality" is meant to be at least two, e.g., two, three, etc., unless explicitly and specifically limited otherwise.

In the present disclosure, unless otherwise expressly specified or limited, the terms "mounted," "connected," "connection," "fixed," etc. are to be understood in a broad sense, for example, as a fixed connection, a removable connection, or a one-piece connection, a mechanical connection, an electrical connection, a direct connection, an indirect connection through an intermediate medium, an internal communication between two components, or an interactive relationship between the two elements, unless otherwise expressly limited. For those skilled in the art, the specific meanings of the above terms in the disclosure may be understood based on specific situations.

In the present disclosure, unless otherwise expressly specified and limited, the first feature "above" or "below" the second feature may be a direct contact between the first and second features, or an indirect contact between the first and second features through an intermediate medium. Moreover, the first feature being "above," "over," and "on" may be that the first feature is directly above or diagonally above the second feature, or simply that the first feature is horizontally higher than the second feature. The first feature being "below," "beneath," and "under" the second feature may be that the first feature is directly below or diagonally below the second feature, or may simply indicate that the first feature is smaller in horizontal height than the second feature.

It may be noted that when an element is the to be "fixed to" or "set on" another element, it may be directly on another element or there may be a centered element. When an element is the to be "connected" to another element, it may be directly attached to the other element or there may be a centered element at the same time. As used herein, the terms "vertical," "horizontal", "up," "down," "left," "right," and similar expressions are used herein for illustrative purposes only and do not indicate the only implementation manner.

Unless otherwise defined, all technical and scientific terms used herein have the same meanings as are commonly understood by those skilled in the art belonging to the disclosure. Terms used herein are for the purpose of describing specific embodiments only, and are not intended to limit the present disclosure. The terms "and/or" as used herein encompass any and all combinations of one or more of the relevant listed items.

One of a core components of a magnetic resonance imaging (MRI) system is a magnet. The magnet provides a stable magnetic field environment. To improve an image quality of the MRI system, a magnetic field uniformity of the MRI system needs to be deployed. To ensure the magnetic field uniformity of the MRI system, a shimming operation may be performed on the MRI system to make a magnetic field strength of the MRI system uniform.

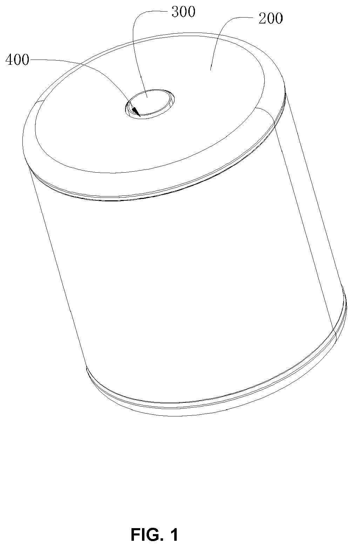

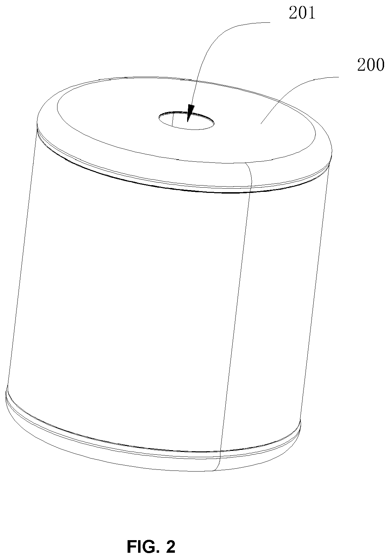

In some embodiments of the present disclosure, referring to FIGs. 1-2, the MRI system that includes a magnet 200 and a gradient coil 300 is provided. The magnet 200 may be provided with a mounting cavity 201. The gradient coil 300 may be provided in a mounting cavity 201. An outer wall of the gradient coil 300 may enclose and form an annular mounting gap 400 with an inner wall of the mounting cavity 201. In some embodiments, the MRI system may be an ultra-high field MRI system, such as a 9.4T (or greater than 9.4T) MRI system. The ultra-high field MRI system may be mainly used for an animal magnetic resonance imaging, which is applied to in vivo life science research of small animals (e.g., mice, rabbits and small monkeys, etc.). In some embodiments, the ultra-high field MRI system may be equipped with gradient coils 300 of different apertures, and the gradient coils 300 of different apertures may be used for different scanning objects and different scenarios.

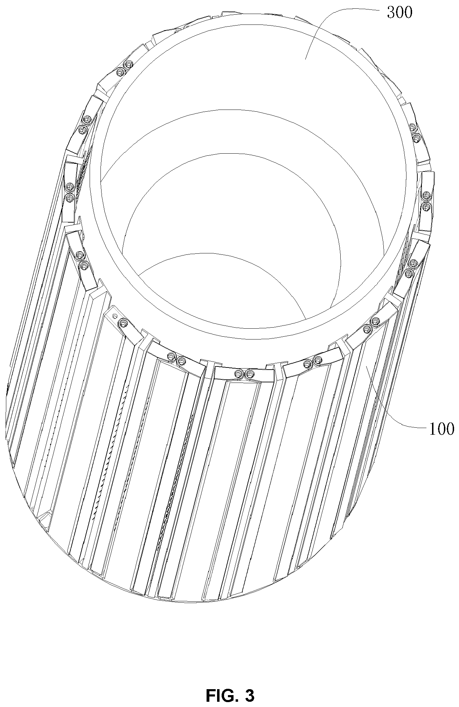

Referring to FIGs. 1-6, some embodiments of the present disclosure also provide a shimming device 100 for an MRI system. The shimming device 100 is a passive shimming device. The MRI system may include a magnet 200 for generating a main magnetic field. The magnet 200 may be provided with a mounting cavity 201. The shimming device 100 may include a shimming structure 110 used to improve a magnetic field uniformity of the main magnetic field. The shimming structure 110 may be disposed within the mounting cavity 201. It may be noted that the shimming structure 110 is disposed within the mounting cavity 201 refers that the shimming structure 110 is disposed within the mounting cavity 201 alone, rather than that the shimming structure 110 is mounted on or within a gradient coil 300. The gradient coil 300 may be detachably connected to the magnet 200, so that when the MRI system changes the gradient coil 300, there may be no need to synchronously change the shimming structure 110. For example, when the MRI system changes the gradient coil 300, there may be no need for the MRI system to reperform a passive shimming operation, which greatly reduces a complexity of the scanning operation of the MRI system.

During a scanning process of the MRI system, the gradient coil 300 may heat the shimming sheet 500, resulting in a severe field drift of the shimming sheet 500, which affects a scanning accuracy of the MRI system. In some embodiments, as shown in FIG. 1- FIG. 3, the gradient coil 300 may be provided in the mounting cavity 201, and an outer wall of the gradient coil 300 may enclose and form an annular mounting gap 400 with an inner wall of the magnet 200. In some embodiments, to ensure a spatial size of a magnetic resonance scan cavity, the mounting gap 400 may be set small enough. A width of the mounting gap 400 may not be greater than 25 mm. That is, a difference between an inner diameter of the mounting cavity 201 of the magnet 200 and an outer diameter of the gradient coil 300 may not be greater than 50 mm. The shimming structure 110 may be disposed within the mounting gap 400. The shimming structure 110 is disposed within the mounting gap 400. For example, the shimming structure 110 is disposed on an outer side of the gradient coil 300. In some embodiments, the shimming structure 110 may have a mounting gap between the shimming structure 110 and the gradient coil 300, the mounting gap may be reserved for easy installation and replacement of the gradient coil. The gradient coil 300 may not heat the shimming sheet 500, thereby effectively avoiding the problem of field drift of the shimming sheet 500. The shimming structure 110 may be disposed between the gradient coil 300 and the magnet 200. For example, the gradient coil 300 may be disposed on an inner side of the shimming structure 110 away from the magnet 200, so that when the MRI system changes the gradient coil 300, the gradient coil 300 may be directly taken away from the shimming structure 110 or put in the shimming structure 110. The connection and mounting of the shimming structure 110 and the magnet 200 may not be affected, which greatly facilitates a use of the MRI system.

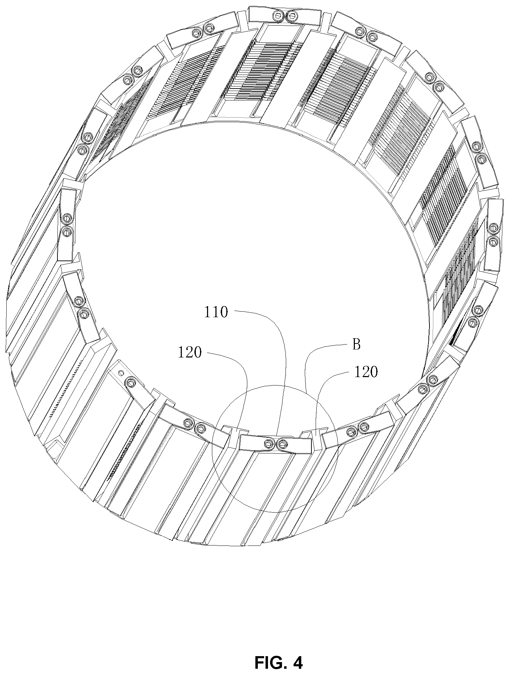

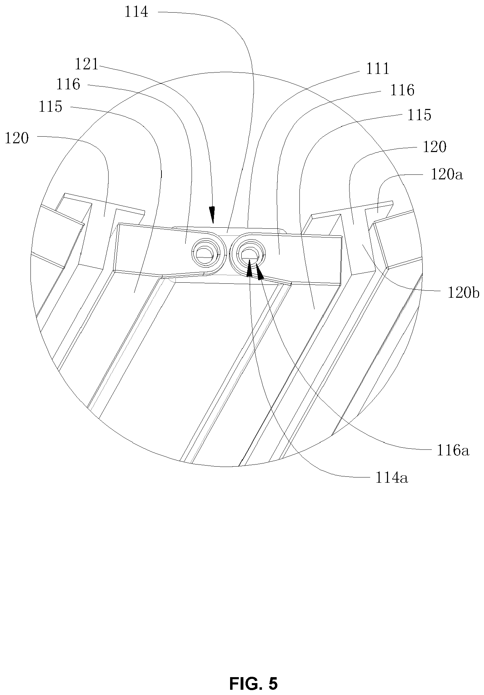

In order to reduce a difficulty of mounting the shimming structure 110, in some embodiments, as shown in FIG. 4 and FIG. 5, the shimming structure 110 may include a plurality of shimming units 111. The plurality of shimming units 111 may extend along an axial direction of the mounting cavity 201, and the plurality of shimming units 111 may be circumferentially distributed within the mounting gap 400 along the inner wall of the mounting cavity 201. Each shimming unit 111 of the shimming structure 110 may be mounted into the mounting cavity 201 one by one. Alternatively, the plurality of shimming units 111 of the shimming structure 110 may first form an entire shimming structure 110 and then the entire shimming structure 110 may be mounted into the mounting cavity 201. In this way, a modular mounting of the shimming structure 110 may be realized, or an integrated mounting of the shimming structure 110 may also be realized, which greatly improves the ease of mounting of the shimming structure 110, and reduces a mounting difficulty.

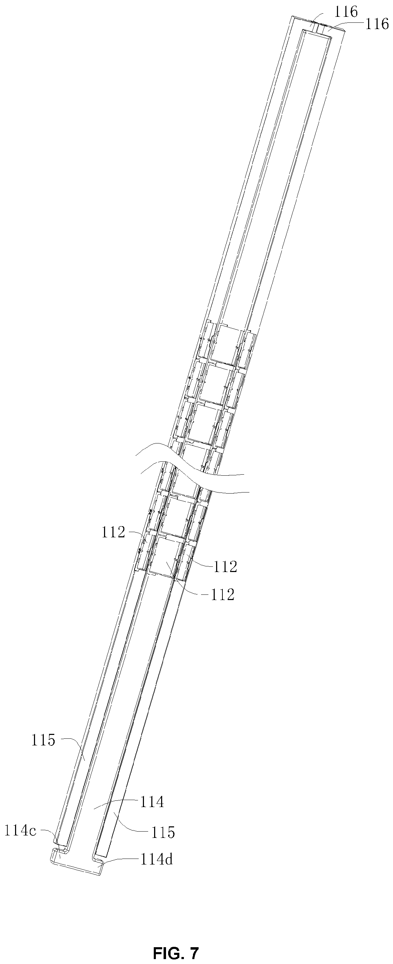

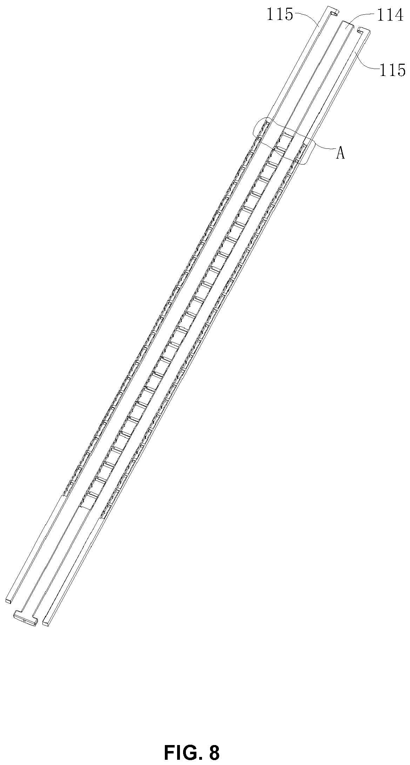

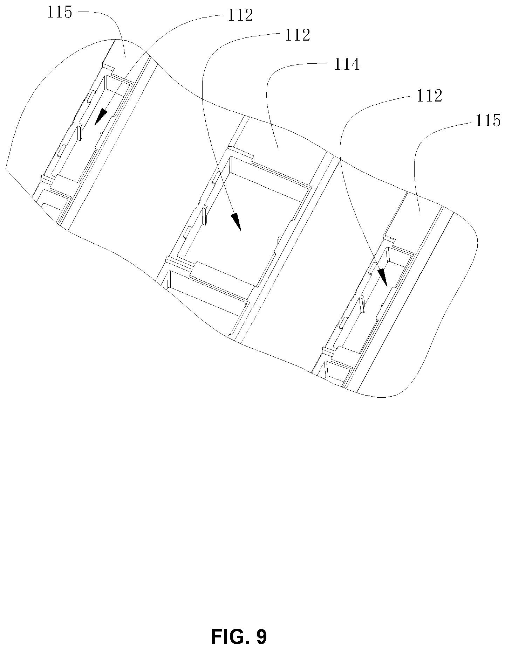

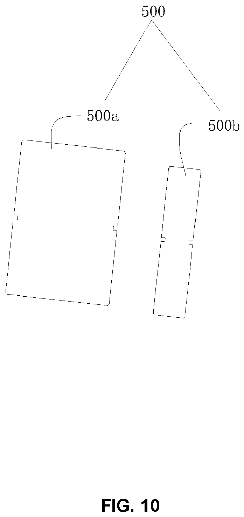

In some embodiments, as shown in FIG. 7-FIG. 10, the shimming unit 111 may be provided with a plurality of placement slots 112 distributed along the axial direction of the mounting cavity 201. Openings of the plurality of placement slots may be oriented towards a side away from the magnet, and the plurality of placement slots may be configured to mount shimming sheets 500. It may be noted that one or more shimming sheets 500 may be mounted in a single placement slot 112 according to actual shimming needs, and of course, some placement slots 112 may not be mounted with the shimming sheets 500. Positions of the placement slots 112 where the shimming sheets need to be installed and a number (or a count) of shimming sheets in each placement slot 112 may be calculated based on data measured after an actual field rise. Moreover, the maximum number of shimming sheets 500 that can be placed in a single placement slot 112 may be determined by a depth of the placement slot 112. For example, the greater the depth of the placement slot 112, the greater the number (or the count) of shimming sheets 500 that can be placed in the placement slot 112, and the better shimming effect can be achieved. In some embodiments, the plurality of placement slots 112 may be distributed at intermediate portions of a lengthwise direction of the shimming unit 111. It may be noted that the lengthwise direction of the shimming unit 111 refers to an axial direction of the mounting cavity 201. For example, the plurality of placement slots 112 being distributed at intermediate portions of the lengthwise direction of the shimming unit 111 refers to that the plurality of placement slots 112 are distributed in a portion of the plurality of shimming units 111 that are located in the middle of the mounting cavity 201.

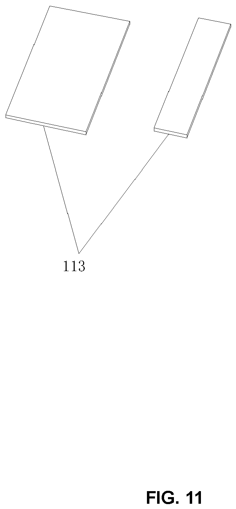

In some embodiments, the opening of the placement slot 112 may be disposed with a slot cover 113, and the slot cover 113 may be detachably connected to the opening of the placement slot 112, as shown in FIG. 11. Specifically, after the shimming sheet 500 is placed in the placement slot 112, the slot cover 113 may be snapped to the opening of the placement slot 112, or the slot cover 113 may be detachably connected to the opening of the placement slot 112 by a fastener. More specifically, a shape of the slot cover 113 may be adapted to a shape of the opening of the placement slot 112, and the slot cover 113 may be provided over the opening of the placement slot 112.

Each of the plurality of shimming units 111 may include a main shimming strip 114 extending along the axial direction of the mounting cavity 201. At least a portion of the plurality of the shimming units 111 may include an auxiliary swimming strip 115 extending along the axial direction of the mounting cavity 201, and the auxiliary swimming strip 115 may be mounted to a side of the main shimming strip 114 along a circumference of the mounting cavity 201. The at least a portion of the plurality of shimming units 111 may be one shimming unit 111, two shimming units 111, three or more shimming units 111, and may be all the shimming units 111. In some embodiments, as shown in FIG. 7-FIG. 9, each shimming unit 111 may include a main shimming strip 114 extending along the axial direction of the mounting cavity 201 and two auxiliary shimming strips 115 extending along the axial direction of the mounting cavity 201. The two auxiliary shimming strips 115 may be mounted on either side of the main shimming strip 114 along the circumference of the mounting cavity 201. In this way, the main shimming sheet 500a may be first mounted within the main shimming strip 114 to initially shim the MRI system. Then the auxiliary shimming sheet 500b may be mounted within the auxiliary shimming strip 115 to perform a second swimming on the MRI system. In this way, a shimming accuracy of the shimming structure 110 may be greatly improved. Moreover, the two auxiliary shimming strips 115 may be assembled on both sides of the main shimming strip 114 along the circumferential direction of the mounting cavity 201, which greatly reduces a difficulty of mounting the shimming unit 111. Moreover, in this arrangement, a space may be fully utilized, and a shimming thickness may be increased to improve the shimming effect. In some embodiments, a number (or a count) of auxiliary shimming strips 115 in the shimming unit 111 may be adjusted according to actual needs. In some embodiments, the number (or count) of auxiliary shimming strips 115 in the one or more shimming units 111 may be one, and the shimming unit 111 may include one main shimming strip 114 extending along the axial direction of the mounting cavity 201 and one auxiliary shimming strip 115 extending along the axial direction of the mounting cavity 201. The one auxiliary shimming strip 115 may be assembled on a side of the main shimming strip 114 along the circumference of the mounting cavity 201. In some embodiments, there may only be the main shimming strip 114 without the auxiliary shimming strip 115 in the one or more shimming units 111. In some embodiments, the above shimming units 111 with different numbers (or counts) of auxiliary shimming strips 115 may be used individually or in combinations, depending on the actual needs.

In some embodiments, a material used for the main shimming sheet 500a mounted on the main shimming strip 114 may be a cobalt steel, and the main shimming sheet 500a mounted on the main shimming strip 114 may be typically with only one specification. The material used for the auxiliary shimming sheet 500b mounted on the auxiliary shimming strip 115 may be the cobalt steel or a carbon steel, and the auxiliary shimming sheet 500b mounted on the auxiliary shimming strip 115 may have a variety of specifications to satisfy the needs for different shimming sizes of the auxiliary shimming field. In some embodiments, a circumferential size of a single auxiliary shimming strip 115 may be smaller than the circumferential size of a single main shimming strip 114. For example, the auxiliary shimming strip 115 may be thinner than the main shimming strip 114. Correspondingly, a width of the circumferential direction of the auxiliary shimming sheet 500b may be smaller than the width of the circumferential direction of the main shimming sheet 500a. It may be appreciated that the circumferential direction herein refers to the circumferential direction of the mounting cavity. By disposing the thin auxiliary shimming strip 115, it may be possible to conveniently disassemble and take out the auxiliary shimming strip 115 in an event of completion of the rising field of the magnet 200, so as to complete the second shimming operation of a strip field.

In some embodiments, as shown in FIG. 5 and FIG. 7, the auxiliary shimming strip 115 may be provided with a connection sheet 116 extending toward the main shimming strip 114 at one end of the auxiliary shimming strip 115, and the auxiliary shimming strip 115 may be detachably connected to one end of the main shimming strip 114 by the connection sheet 116. The auxiliary shimming strip 115 may be withdrawn from both sides of the main shimming strip 114. Specifically, the auxiliary shimming strip 115 may be in a L-shaped as a whole. The connection sheet 116 may be provided with a first threaded hole 116a. The main shimming strip 114 may be provided with a second threaded hole 114a corresponding to the first threaded hole 116a. The main shimming strip 114 and the auxiliary shimming strip 115 may be sequentially threaded by means of fastening screws (not shown in the drawings) to realize a threaded connection of the main shimming strip 114 and the auxiliary shimming strip 115.

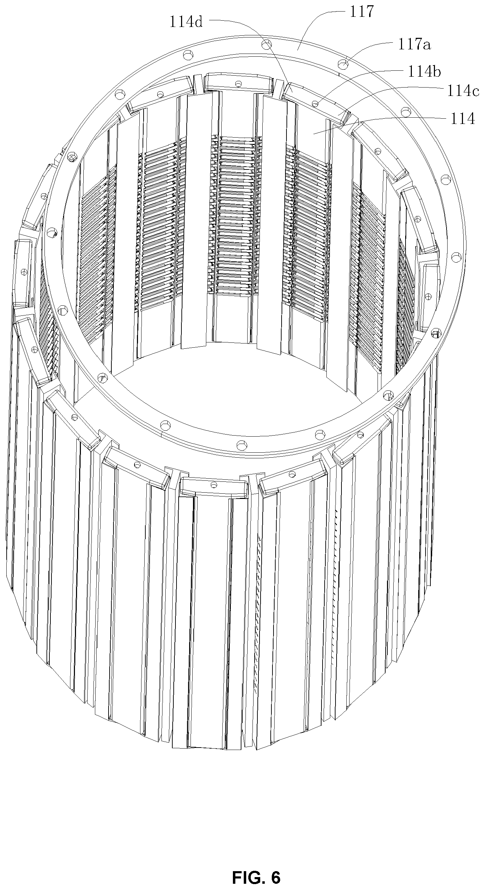

In some embodiments, as shown in FIG. 6, the shimming structure 110 may further include a fixing ring 117. An end of each of a plurality of main shimming strips 114 that is away from the connection sheet 116 may be detachably mounted to the fixing ring 117. Specifically, the fixing ring 117 may be provided with a third threaded hole 117a, and the main shimming strip 114 may be provided with a fourth threaded hole 114b corresponding to the third threaded hole 117a. The main shimming strip 114 and the fixing ring 117 may be threadedly connected by fastening screws (not shown in the figure) sequentially threaded through the third threaded holes 117a and the fourth threaded holes 114b. In this way, the main shimming strip 114 distributed circumferentially by the fixing ring 117 may be fixedly connected. Combining the auxiliary shimming strip 115 being detachably connected to the main shimming strip 114, the entire shimming structure 110 may be fixedly mounted together by the fixing ring 117, and a structural strength of the entire shimming structure 110 may be improved. More specifically, the main shimming strip 114 may be T-shaped. The main shimming strip 114 may be provided with a first stop portion 114c and a second stop portion 114d. Ends of the auxiliary shimming strips 115 disposed on both sides of the main shimming strip 114 away from the connection sheet 116 may be stopped at the first stop portion 114c and the second stop portion 114d, respectively. The T-shaped main shimming strip 114 may be mounted in conjunction with the two L-shaped auxiliary shimming strips 115, which is easy to assemble and makes a full use of the mounting space.

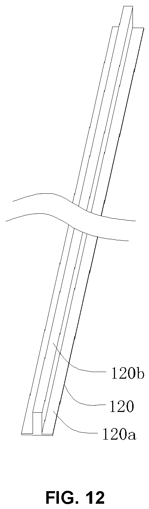

In some embodiments, as shown in FIG. 5 and FIG. 12, the magnet 200 may be connected with a plurality of limit strips 120 disposed in the circumferential direction along the inner wall of the magnet 200. At least a portion of adjacent limit strips 120 and the inner wall of the magnet 200 may enclose and form a first limit slot 121. At least a portion of the shimming unit 111 may be disposed within the first limit slot 121. In some embodiments, the limit strip 120 may have a T-shaped cross-section and the limit strip 120 may be connected to the inner wall of the magnet 200. The limit strip 120 may include a snapping portion 120a and a connection portion 120b. One end of the connection portion 120b may be connected to the snapping portion 120a, and the other end of the connection portion 120b may be fixedly connected to the inner wall of the magnet 200. The connection portion 120b may be a ribbed plate of the T-shaped limit strip 120. The connection portion 120b may be distributed along a circumferential direction of the magnet 200, and the first limit slot 121 may be formed between two adjacent connection portions 120b. The connection portion 120b may serve as a sidewall of the first limit slot 121. One shimming unit 111 may be mounted in each of the first limit slots 121, and the connection portions 120b may divide each of the shimming units 111 along the circumferential direction of the magnet 200. The snapping portion 120a may be a wing plate of the T-shaped limit strip 120. The limit strip 120 may limit the shimming units 111 along the radial direction of the magnet 200. By using the T-shaped limit strip 120, a full utilization of the mounting gap 400 may be realized, so as to reduce the radial size of the limit structure for mounting the shimming unit 111, and increase an available thickness of the shimming unit 111 to achieve good shimming effect. In some embodiments, the connection portion 120b of the limit strip 120 may be fixed to the inner wall of the magnet 200 by welding. In some embodiments, the connection portion 120b may be directly extended along the axial direction of the mounting cavity 201. For example., two ends of a lengthwise direction of the connection portion 120b may be fixed by welding to the inner wall of the magnet 200. A middle portion of the connection portion 120b extending along the axial direction of the mounting cavity 201 may not be welded to the magnet 200, so as to reduce the processing difficulty. When the shimming unit 111 is disposed in the first limit slot 121, a side of the shimming unit 111 away from the inner wall of the magnet 200 may abut against the snapping portion 120a. In some embodiments, the snapping portion 120a may have a thickness of 1.2 mm or less than 1.2 mm. In some embodiments, the thickness of the snapping portion 120a along the radial direction of the magnet 200 may be 0.5-1.0 mm. Controlling the thickness of the snapping portion 120a to less than 1.2 mm may ensure a strength of the connection and minimize the radial space occupied by the limit strip 120. In some embodiments, the snapping portion 120a of the T-shaped limit strip 120 may be in a shape of a curved surface, and the curved surface may be adapted to fit into the annular mounting gap 400. In some embodiments, the snapping portion 120a of the T-shaped limit strip 120 may also be a planar shape. A width of the snapping portion 120a along the circumference of the magnet may be 20-30 mm. The width of the snapping portion 120a may be small enough, and the planar shape may be used directly, which is convenient for manufacturing and processing. In some embodiments, the snapping portion 120a and the connection portion 120b may be connected by welding to form the T-shaped limit strip 120. In some embodiments, a width of the mounting gap 400 (e.g., a gap along the radial direction of the magnet 200) may not be greater than 25 mm. A height of the connection portion 120b along the radial direction of the magnet 200 may not be greater than 24 mm. A thickness of the snapping portion 120a along the radial direction of the magnet 200 may not be greater than 1.0 mm. The connection portion 120b may be fixed directly to the inner wall of the magnet 200 by welding, so as to fully utilize a space of the mounting gap 400. In some embodiments, the thickness of the connection portion 120b along the circumferential direction of the magnet 200 may not be greater than 5.0 mm, which ensures a number and sizes of the circumferentially distributed shimming units 111 while ensuring the fixing strength.

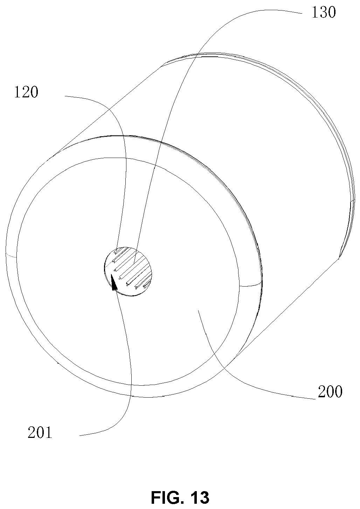

In some embodiments, as shown in FIG. 13, a magnetic field assembly for the MRI system is provided. The magnetic field assembly may include a magnet 200 and a limit structure 130 for mounting the plurality of shimming units 111. The magnet 200 may be provided with the mounting cavity 201. The limit structure 130 may include a plurality of limit strip 120. The plurality of limit strips 120 may be distributed along the circumferential direction of the mounting cavity 201 and may be connected to the inner wall of the magnet 200. Adjacent limit strips 120 and the inner wall of the magnet 200 may enclose and form a first limit slot 121. The first limit slot 121 may be configured to mount the plurality of shimming units 111. In some embodiments, the cross-section a limit strips 120 of the plurality of limit strips 120 may be in the T-shape, and the limit strip 120 may be connected to the inner wall of the magnet 200. The specific structure of the limit strip 120 may be the limit strip 120 described in any of the above embodiments. In some embodiments, the limit structure 130 may further include at least two support strips 123. The at least two support strips 123 may be distributed along a circumferential direction of the inner wall of the magnet 200 on both sides of a symmetry axis of the inner wall of the magnet 200 along the direction of gravity, and may be connected to the inner wall of the magnet 200. The at least two support strips 123 may support the gradient coil 300. In some embodiments, a support strip 123 of the at least two support strips 123 may be disposed adjacent to at least one limit strip 120. The support strip 123 and the adjacent limit strip 120 and the inner wall of the magnet 200 may enclose and form a second limit slot 122 extending along the axial direction of the mounting cavity 201. At least a portion of the plurality of shimming units 111 may be disposed within the second limit slot 122.

In some embodiments, an MRI system including a magnet 200 and a shimming device 100 is provided. The shimming device 100 may be the shimming device 100 described in any of the above embodiments. The magnet 200 may be provided with a mounting cavity 201, and the shimming device 100 may be disposed within the mounting cavity 201. In some embodiments, the MRI system may further include a gradient coil 300. The shimming device 100 may include a shimming sheet 500. The shimming sheet 500 may be disposed within the shimming structure 110, and the shimming structure 110 may be disposed between the magnet 200 and the gradient coil 300. In some embodiments, a gap may exist between the shimming device 100 and the gradient coil 300. The gap may be an interval between the outer wall of the gradient coil 300 and the shimming device 100. For example, the shimming device 100 is annular, and the gap may be an annular gap. In some embodiments, the MRI system may be an MRI system in which the gradient coils are replaceable, e.g., the gradient coils of different sizes and parameters may be replaced. In some embodiments, the MRI system may be an ultra-high field MRI system, for example, a 7T (or greater than 7T) field strength MRI system. In some embodiments, the MRI system may be a preclinical MRI system (e.g., an animal MRI system).

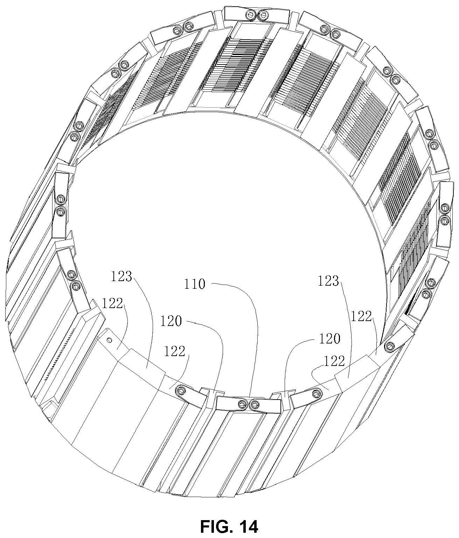

In some embodiments, as shown in FIG. 14, the magnet 200 may further be connected to at least two support strips 123 disposed in a circumferential direction along the inner wall of the magnet 200. The support strip 123 may have a radial height on the magnet 200 greater than the height of the limit strip 120, so as to enable the support strip 123 to abut against the gradient coil 300. The support strip 123 may support the gradient coil 300. In some embodiments, in a projection along the axis direction of the magnet 200, the support strips 123 may be distributed on both sides of the symmetry axis of the inner wall of the magnet 200 along a direction of gravity, thereby improving a stability of the support of the gradient coil 300. In some embodiments, the support strip 123 may be disposed adjacent to at least one limit strip 120. The support strip 123, the adjacent limit strip 120, and the inner wall of the magnet 200 may enclose and form a second limit slot 122 extending along the axial direction of the mounting cavity 201. At least a portion of the plurality of shimming units 111 may be disposed within the second limit slot 122. That is, when the magnet 200 is provided with the support strip 123, the support strip 123 may be provided between a portion of the adjacent limit strips 120, and the portion of the adjacent limit strips 120 that are not provided with the support strip 123 may form the first limit slot 121 with the inner wall of the magnet 200. At this time, a portion of the plurality of shimming units 111 may be disposed in the first limit slot 121, and another portion of the plurality of shimming units 111 may be disposed in the second limit slot 122. In some embodiments, there may be no support strip 123 connected to the magnet 200, so that the second limit slot 122 may not be formed, and only the first limit slot 121 may be included on the inner wall of the magnet 200, and all the plurality of shimming units 111 may be placed within the first limit slot 121. In some embodiments, the size of the support strip 123 in the circumferential direction of the magnet 200 may be greater than the size of the limit strip 120, such that the space available in the second limit slot 122 is smaller than the space available in the first limit slot 121. In some embodiments, a shimming unit 111 with the auxiliary shimming strip 115 may be placed within the second limit slot 122. In other embodiments, a shimming unit 111 without the auxiliary shimming strip 115 may also be placed within the second limit slot 122. In other embodiments, the second limit slot 122 may also have enough space to place the shimming unit 111 with two auxiliary shimming strips 115.

In some embodiments, a shimming method for a magnetic resonance imaging system is also provided. The shimming method adopts the shimming device 100 with the main shimming strip 114 and the auxiliary shimming strip 115. In some embodiments, the shimming method may adopt the shimming device 100 described in any one of the embodiments. In some embodiments, the MRI system may be the MRI system described in any one of the embodiments above. In some embodiments, the shimming method may include the following operations: measuring a first magnetic field distribution of a main magnetic field of the magnet 200 for a first time; mounting, based on the first magnetic field distribution, the main shimming strip 114 with the main shimming sheet 500a between the magnet 200 and the gradient coil 300; measuring a second magnetic field distribution of the main magnetic field of the magnet 200 for a second time; and mounting, based on the second magnetic field distribution, the auxiliary shimming strip 115 with the auxiliary shimming sheet 500b between the main shimming strips 114.

Typically, the distribution of the main magnetic field may be measured for several times using a measuring probe (not shown in the figure). Specifically, the limit strip 120 may first be welded to the inner wall of the magnet 200. Then, the magnetic field distribution of the main magnetic field may be measured for the first time by using a measuring probe. Then, based on the distribution of the main magnetic field, the main shimming strip 114 provided with the main shimming sheet 500a may be mounted in the first limit slot 121. The magnetic field distribution of the main magnetic field may then be measured again, and a number (or a count) of auxiliary shimming sheets 500b to be placed in each placement slot 112 of the auxiliary shimming strip 115 may be calculated according to the main magnetic field distribution data measured. Finally, the auxiliary shimming strip 115 placed with the auxiliary shimming sheets 500b may be inserted in sequence, and the auxiliary shimming strip 115 may be detachably connected to the main shimming strip 114, and the shimming may be completed. Of course, the shimming situation of the main magnetic field may further be measured for several times, and the auxiliary shimming strip 500b placed in each placement slot 112 of the auxiliary shimming strip 115 may be adjusted to achieve the shimming effect.

More specifically, the main shimming sheet 500a may be placed into and fixed to the main shimming strip 114. Each of the plurality of main shimming strips 114 may be provided with two second threaded holes 114a, and each of the auxiliary shimming strips 115 may be provided with a first threaded hole 116a corresponding to each of the second threaded holes 114a. The auxiliary shimming strips 115 may be fixed on the main shimming strips 114 by threading fastening screws sequentially through the first threaded holes 116a and the second threaded holes 114a. There may be 16 main shimming strips 114 along the circumferential direction of the mounting gap 400. The main shimming strips 114 may carry greater main shimming sheets 500a, and the main shimming's 114 may complete a pre-shimming of the magnet 200 at factory. In some embodiments, before delivery to a customer, a field rise of the magnet 200 may be completed at the factory, and the first measurement of the magnetic field distribution of the main magnetic field may be performed. Based on the first magnetic field distribution, the main shimming strip 114 with the main shimming sheet 500a may be mounted between the magnet 200 and the gradient coil 300. The pre-shimming of the magnet 200, i.e., the first shimming, may be completed at the factory. After a field drop, the magnet 200 may be shipped to an installation site for customer use. There may be 32 auxiliary shimming strips 115. The auxiliary shimming strips 115 may be capable of carrying smaller auxiliary shimming sheets 500b. The auxiliary shimming strips 115 may usually be used for second shimming at the installation site of the MRI system. The auxiliary shimming strips may be designed to be relatively lightweight, and the auxiliary shimming strip 115 may be inserted or withdrawn from the first limit slot 121 according to an operation procedure in an environment with the magnetic field, so as to achieve a better shimming effect. In some embodiments, the rising of the field of the magnet 200 may be completed again at the installation site. The magnetic field distribution of the main magnetic field may be measured for a second time. Based on the magnetic field distribution measured for the second time, the auxiliary shimming strip 115 with the auxiliary shimming sheet 500b may be installed between the main shimming strips 114 to complete the second shimming. In some embodiments, the second shimming may be performed for a plurality of times until a shimming requirement is satisfied.

To fix the shimming unit 111 formed by the connection between the main shimming strip 114 and the auxiliary shimming strips 115. The MRI system may weld a circle of T-shaped limit strips 120 inside the mounting hole of the magnet 200. One main shimming strip 114 and two auxiliary shimming strips 115 may be placed between every two T-shaped limit strips 120, the auxiliary shimming strips 115 being distributed on both sides of the main shimming strip 114. The auxiliary shimming strips 115 may be fixed to the main shimming strip 114 by M5 screws. The main shimming strips 114, the auxiliary shimming strips 115, and the corresponding first limit slots 121 may be numbered, respectively, and the main shimming strip 114 may be numbered sequentially as 1, 2, 3,... ..., 14, 15, and 16. The 32 auxiliary shimming strips 115 may be numbered as 1A, 1B, 2A, 2B,... ..., 15A, 15B, 16A, and 16B, and the numbers may be labeled at corresponding positions of the first limit slot 121 to ensure accurate installation positions of the main shimming strip 114 and the auxiliary shimming.

Each of the main shimming strip 114 and the auxiliary shimming strip 115 contains 25 placement slots 112. The placement slots 112 may be placed with a corresponding number of shimming sheets 500 as required. A size and a number of the shimming sheets 500 may be determined by positions of the shimming sheets 500 and compensating magnetic fields required to be generated. The compensating magnetic field may be measured using a measuring probe. Then, according to a magnetization formula, the number of shimming sheets 500 required in each of the placement slots 112 may be calculated. Further, through the placement of the shimming sheets 500, the main magnetic field may be compensated, until an index of magnetic field uniformity required for the MRI system to perform imaging is achieved.

The various technical features of the above-described embodiments may be combined arbitrarily. For the sake of conciseness of the description, all possible combinations of the various technical features of the above-described embodiments have not been described. However, as long as there is no contradiction in the combinations of such technical features, they should be considered to be within the scope of the present disclosure.

Those skilled in the art may recognize that the above embodiments are used only to illustrate the present disclosure, and are not intended to be used as a limitation of the disclosure, and that as long as appropriate alterations and variations to the above embodiments are made within the substantial spirit of the disclosure, they may fall within the scope of protection claimed herein.

## Claims

1. A shimming device for a magnetic resonance imaging system, the magnetic resonance imaging system including a magnet (200) for generating a main magnetic field, wherein the magnet (200) is provided with a mounting cavity (201), and the shimming device (100) includes a shimming structure (110) disposed within the mounting cavity (201).

2. The shimming device of claim 1, wherein the mounting cavity (201) is configured to mount a gradient coil (300), an outer wall of the gradient coil (300) forms an annular mounting gap (400) with an inner wall of the magnet (200), and the shimming structure (110) is disposed within the annular mounting gap (400).

3. The shimming device of claim 2, wherein the shimming structure (110) includes a plurality of shimming units (111) extending along an axial direction of the mounting cavity (201), the plurality of shimming units (111) being distributed along a circumferential direction of an inner wall of the mounting cavity (201).

4. The shimming device of claim 3, wherein the plurality of shimming units (111) are provided with a plurality of placement slots (112) distributed along the axial direction of the mounting cavity (201), openings of the plurality of placement slots (112) being oriented towards a side away from the magnet (200), and the placement slots (112) being configured to mount shimming sheets (500).

5. The shimming device of claim 4, wherein the plurality of the placement slots (112) are distributed in a middle portion of a lengthwise direction of the plurality of shimming units (111).

6. The shimming device of claim 3, wherein
each shimming unit of the plurality of shimming units (111) includes a main shimming strip (114) extending along the axial direction of the mounting cavity (201);
at least a portion of the plurality of the shimming units (111) include an auxiliary shimming strip (115) extending along the axial direction of the mounting cavity (201); and
the auxiliary shimming strip (115) is assembled on a side of the main shimming strip (114) along a circumference of the mounting cavity (201).

7. The shimming device of claim 6, wherein the plurality of shimming units (111) include two auxiliary shimming strips (115) assembled on both sides of the main shimming strip (114) along the circumferential direction of the mounting cavity (201); and/or
the plurality of shimming units (111) include an auxiliary shimming strip (115) assembled on one side of the main shimming strip (114) along the circumferential direction of the mounting cavity (201).

8. The shimming device of claim 6, wherein the shimming structure (110) further includes a fixing ring (117), one end of the main shimming strip (114) is detachably mounted on the fixing ring (117), and the other end of the main shimming strip (114) is connected to the auxiliary shimming strip (115).

9. The shimming device of claim 3, wherein the magnet (200) is connected with a plurality of limit strips (120) distributed along a circumferential direction of the inner wall of the magnet (200), at least a portion of adjacent limit strips (120) and the inner wall of the magnet (200) enclose and form a first limit slot (121) extending along an axial direction of the mounting cavity (201), and at least a portion of the plurality of shimming units (111) are disposed within the first limit slot (121).

10. The shimming device of claim 9, wherein each of the plurality of limit strips (120) has a T-shaped cross-section and the plurality of limit strips (120) are connected to the inner wall of the magnet (200).

11. A magnetic field assembly for a magnetic resonance imaging system, wherein
the magnetic field assembly includes a magnet (200) and a limit structure (130) for mounting a plurality of shimming units (111),
the magnet (200) is provided with a mounting cavity (201),
the limit structure (130) includes a plurality of limit strips (120) distributed along a circumferential direction of the mounting cavity (201),
the plurality of limit strips (120) are connected to an inner wall of the magnet (200),
at least a portion of adjacent limit strips (120) and the inner wall of the magnet (200) enclose and form a first limit slot (121) extending along an axial direction of the mounting cavity (201), and
the first limit slot (121) is configured to mount at least a portion of the plurality of shimming units (111).

12. The magnetic field assembly of claim 11, wherein the limit structure (130) further includes at least two support strips (123) distributed along a circumferential direction of the inner wall of the magnet (200) on both sides of a symmetry axis of the inner wall of the magnet (200), the symmetry axis is along a direction of gravity, and the at least two support strips (123) are connected to the inner wall.

13. The magnetic field assembly of claim 12, wherein the support strip (123) is provided adjacent to at least one of the plurality of limit strips (120), the support strip (123), an adjacent limit strip (120), and the inner wall of the magnet (200) enclose and form a second limit slot (122) extending along the axial direction of the mounting cavity (201), and at least a portion of the plurality of shimming units (111) are disposed within the second limit slot (122).

14. A magnetic resonance imaging system including a magnet (200) and a shimming device (100) of any one of claims 1-9, wherein the magnet (200) is provided with a mounting cavity (201), and the shimming device (100) is disposed within the mounting cavity (201).

15. The magnetic resonance imaging system of claim 14, wherein the magnetic resonance imaging system further includes a gradient coil (300), the shimming device (100) is disposed between the magnet (200) and the gradient coil (300), and there is a gap between the shimming device (100) and the gradient coil (300).

16. The magnetic resonance imaging system of claim 15, wherein the magnet (200) is further connected to at least two support strips (123), the at least two support strips (123) are distributed along a circumferential direction of an inner wall of the magnet (200), and the at least two support strips (123) abuts against the gradient coil.

17. The magnetic resonance imaging system of claim 16, wherein the at least two support strips (123) are distributed on both sides of a symmetry axis of the inner wall of the magnet (200) along a direction of gravity.

18. The magnetic resonance imaging system of claim 16, wherein a support strip (123) of the at least two support strips (123) is provided adjacent to at least one of a plurality of limit strips (120), the support strip (123), an adjacent limit strip (120), and the inner wall of the magnet (200) enclose and form a second limit slot (122) extending along an axial direction of the mounting cavity (201), and at least a portion of a plurality of shimming units (111) are disposed within the second limit slot (122).

19. A shimming method for a magnetic resonance imaging system, wherein a shimming device (100) with a main shimming strip (114) and an auxiliary shimming strip (115) are used, the shimming method comprises:
measuring a first magnetic field distribution of a main magnetic field of a magnet (200) for a first time;
mounting, based on the first magnetic field distribution, the main shimming strip (114) with a main shimming sheet (500a) between a magnet (200) and a gradient coil (300);
measuring a second magnetic field distribution of the main magnetic field of the magnet (200) for a second time; and
mounting, based on the second magnetic field distribution, the auxiliary shimming strip (115) with an auxiliary shimming sheet (500b) between the main shimming strip (114).

20. The shimming method of claim 19, wherein the first magnetic field distribution of the main magnetic field of the magnet (200) is measured at a factory, and the second magnetic field distribution of the main magnetic field of the magnet (200) is measured at an installation site of the shimming device.
